# EUROPÄISCHE PATENTANMELDUNG

(11) **EP 4 541 936 A2**
(43) Veröffentlichungstag der Anmeldung: **23.04.2025**
(21) Anmeldenummer: 25162659.4
(22) Anmeldetag: 25.10.2018
(51) Int. Cl.: C23C 16/54

(54) **VERFAHREN UND VORRICHTUNG ZUR KONTINUIERLICHEN GASPHASENABSCHEIDUNG VON SILIZIUM AUF SUBSTRATEN**

(30) Priorität: 27.10.2017 DE 102017125232
(62) Teilanmeldung aus: 18793404.7
(71) Anmelder: Nexwafe GmbH, 79108 Freiburg (DE)
(72) Erfinder: REBER, Stefan, 79194 Gundelfingen (DE); SCHILLINGER, Kai, 79106 Freiburg (DE)
(74) Vertreter: LBP Lemcke, Brommer & Partner Patentanwälte mbB

(57) **Zusammenfassung**

Verfahren zur kontinuierlichen Gasphasenabscheidung von Silizium auf Substraten, welches die folgenden Schritte aufweist:
(a) Einbringen von zumindest einem Substrat in eine Reaktionskammer (2);
(b) Einleiten eines Prozessgases sowie zumindest einer gasförmigen Silizium-Vorläuferverbindung in die Reaktionskammer (2);
(c) Bildung eines gasförmigen Gemisches aus zumindest einem auf Silizium basierenden Zwischenprodukt in Koexistenz mit der gasförmigen Silizium-Vorläuferverbindung und dem Prozessgas in der Reaktionskammer (2);
(d) Bildung einer Siliziumschicht durch Gasphasenabscheidung von Silizium aus der gasförmigen Silizium-Vorläuferverbindung und/oder des auf Silizium basierenden Zwischenprodukts auf dem Substrat;
(e) Abführen eines Überschusses des gasförmigen Gemisches aus der Reaktionskammer (2);
wobei das Verfahren weiterhin einen Schritt (f) aufweist, bei dem zumindest einer der Bestandteile des Überschusses des gasförmigen Gemisches, ausgewählt aus der Silizium-Vorläuferverbindung, dem auf Silizium basierenden Zwischenprodukt und/oder dem Prozessgas, in die Reaktionskammer (2) rückgeführt wird. Das Verfahren ist dadurch gekennzeichnet, dass in dem Verfahren das Einleiten der gasförmigen Silizium-Vorläuferverbindung in die Reaktionskammer (2) derart geregelt wird, dass das Molverhältnis von dem auf Silizium basierenden Zwischenprodukt zu der Silizium-Vorläuferverbindung einen Wert von 0,2:0,8 bis 0,5:0,5, bevorzugt 0,3:0,7 bis 0,5:0,5, besonders bevorzugt 0,5:0,5 im Prozessgas aufweist, wobei es sich bei der Silizium-Vorläuferverbindung um Siliziumtetrachlorid und bei dem auf Silizium basierenden Zwischenprodukt um Trichlorsilan und bei dem Prozessgas um Wasserstoff handelt.

## Beschreibung

Durch chemische Gasphasenabscheidung von Silizium auf Substraten lassen sich Siliziumschichten mit einer Schichtdicke von 1 bis 200 µm herstellen, welche Anwendung in Solarzellen und in der Mikroelektronik finden. Im Gegensatz zum konventionellen Herstellungsverfahren durch Sägen von Siliziumblöcken aus dem Czochralski- oder Zonenschmelz-Verfahren werden bei der chemischen Gasphasenabscheidung Sägeverluste vermieden. Zudem können große Mengen an Silizium und somit erhebliche Kosten aufgrund der geringen Schichtdicke im Vergleich zu den konventionell hergestellten Silizium-Wafern mit einer Schichtdicke im Bereich von 200 bis 300 µm eingespart werden.

Bei der chemischen Gasphasenabscheidung wird ein Substrat in eine Reaktionskammer eingebracht und auf 700°C bis 1400°C erhitzt. Daraufhin wird eine Silizium-Vorläuferverbindung in die Reaktionskammer eingeleitet, welche sich in der Reaktionskammer thermisch zersetzt, wodurch sich festes Silizium auf dem Substrat abscheidet. Mögliche Nebenprodukte dieser chemischen Reaktion sowie der Überschuss an der Silizium-Vorläuferverbindung werden aus der Reaktionskammer abgeleitet. Durch die chemische Gasphasenabscheidung lassen sich neben polykristallinen auch monokristalline Siliziumschichten durch chemischer Gasphasenepitaxie auf kristallinen Substraten erzeugen.

Als Silizium-Vorläuferverbindung eignen sich u.a. Silane sowie Chlorsilane, wobei die Verwendung von Silanen aufgrund deren Selbstentzündlichkeit in Kontakt mit Luftsauerstoff sowie die Neigung zur Gasphasennukleation nachteilig ist. Im Fall von Chlorsilanen wird die Silizium-Abscheidereaktion am Substrat in der Gegenwart von Wasserstoff als Prozessgas durchgeführt und verläuft gemäß der vereinfachten Reaktionsgleichung:

SiH₍₄₋ₙ₎Clₙ + (n-2) H₂ → Si + n HCl

Hierbei hat sich gezeigt, dass Siliziumtetrachlorid (n=4) bis 1600 °C thermisch stabil ist. Erst durch Zugabe von Wasserstoff kommt es zur Abscheidung von Silizium auf dem Substrat. Zusätzlich werden jedoch auch gasförmige niedere Chlorsilane in der Reaktionskammer bzw. beim Abkühlen nach Durchlaufen der Reaktionskammer wie beispielsweise Trichlorsilan (n=3) und Dichlorsilan (n=2) in Abhängigkeit von H₂ Konzentration, Temperatur und Druck gebildet, gemäß:

*x* SiCl₄ + *y* H₂ 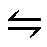

Si + a SiCl₄ + *b* SiHCl₃ + *c* SiH₂Cl₂ + HCl

Diese Zwischenprodukte zersetzen sich ebenfalls thermisch und führen zur Abscheidung von Silizium bei deutlich niedrigeren Temperaturen ab 700 °C. Dadurch kommt es nicht nur auf der Substratoberfläche zur Abscheidung von Silizium, sondern auch in den Gaszufuhr- und Gasabfuhrleitungen der Reaktionskammer. Diese sogenannten parasitären Abscheidungen führen zu einer Verringerung des Querschnitts dieser Fluidleitungen und müssen daher regelmäßig entfernt werden um sämtliche Querschnitte zu erhalten.

In der DE 10 2005 045 582 ist beispielsweise ein Verfahren zur kontinuierlichen Gasphasenabscheidung von Silizium auf Substraten beschrieben, bei dem durch periodische Änderung der Zusammensetzung des zugeführten Gases parasitäre Abscheidungen in der Vorrichtung entfernt und/oder deren Bildung verhindert wird unter gleichzeitiger Silizium-Abscheidung auf den Substraten. Hierfür wird der Reaktionskammer in periodischen Abständen ein Ätzgas, nämlich Chlorwasserstoff zugeführt, welcher zur Entfernung von parasitären Abscheidungen dient. Ein derartiges Verfahren hat den Nachteil, dass in Anwesenheit des Ätzgases der Durchsatz an mit Silizium beschichteten Substraten deutlich sinkt, da jegliches festes Silizium, also nicht nur die parasitären Abscheidungen, in Gegenwart von Chlorwasserstoff zu gasförmigen Trichlorsilan umgesetzt wird. Dies führt zum einen zur Verringerung der Schichtdicke der Siliziumschicht und zum anderen erhöht die Verwendung eines weiteren Gases die Produktionskosten.

Die WO 2011/084427 A2 offenbart schließlich ein Verfahren zur Herstellung von Silizium mittels Gasphasenabscheidung in einer Reaktionskammer, wobei Reaktionsnebenprodukte für die Verwendung innerhalb der Systeme und Prozesse ohne Rückgewinnung und externe Verarbeitung der Nebenprodukte recycelt werden, wobei eine Bestimmung des Gehalts an Chlorsilanen im Volumen des Vor-Disproportionierungsreaktors erfolgt.

Der vorliegenden Erfindung liegt daher die Aufgabe zugrunde, ein Verfahren sowie eine Vorrichtung zur Gasphasenabscheidung von Silizium auf Substraten anzugeben, wodurch die Bildung von parasitären Abscheidungen verhindert oder zumindest verringert und der Durchsatz gegenüber dem aus dem Stand der Technik bekannten Verfahren erhöht werden kann.

Diese Aufgabe wird erfindungsgemäß durch ein Verfahren mit den Merkmalen des Anspruchs 1 sowie eine Vorrichtung mit den Merkmalen des Anspruchs 9 gelöst.

Vorteilhafte Weiterbildungen der erfindungsgemäßen Idee sind Gegenstand von Unteransprüchen.

Die Erfindung betrifft ein Verfahren zur kontinuierlichen Gasphasenabscheidung von Silizium auf Substraten gemäß Oberbegriff des Anspruchs 1. Weiterhin betrifft die Erfindung eine Vorrichtung zur kontinuierlichen Gasphasenabscheidung von Silizium auf Substraten nach dem Oberbegriff des Patentanspruchs 9.

Das erfindungsgemäße Verfahren zur kontinuierlichen Gasphasenabscheidung von Silizium auf Substraten weist folgende Verfahrensschritte auf:
In einem Verfahrensschritt (a) erfolgt ein Einbringen von zumindest einem Substrat in eine Reaktionskammer. In einem Verfahrensschritt (b) erfolgt ein Einleiten eines Prozessgases sowie zumindest einer gasförmigen Silizium-Vorläuferverbindung in die Reaktionskammer. Daraufhin wird in einem Verfahrensschritt (c) ein gasförmiges Gemisch aus zumindest einem auf Silizium basierenden Zwischenprodukt in Koexistenz mit der gasförmigen Silizium-Vorläuferverbindung und dem Prozessgas in der Reaktionskammer gebildet. Im darauffolgenden Verfahrensschritt (d) wird eine Siliziumschicht durch Gasphasenabscheidung von Silizium aus der Silizium-Vorläuferverbindung und/oder des auf Silizium basierenden Zwischenprodukts auf dem Substrat gebildet. In einem Verfahrensschritt (e) erfolgt ein Abführen eines Überschusses des gasförmigen Gemisches aus der Reaktionskammer.

Bei dem erfindungsgemäßen Verfahren ist wesentlich, dass in Verfahrensschritt (f) zumindest einer der Bestandteile des Überschusses des gasförmigen Gemisches, ausgewählt aus der Silizium-Vorläuferverbindung, dem auf Silizium basierenden Zwischenprodukt und/oder dem Prozessgas, in die Reaktionskammer rückgeführt wird, wobei in dem Verfahren das Einleiten der Silizium-Vorläuferverbindung in die Reaktionskammer derart geregelt wird, dass das Molverhältnis von dem auf Silizium basierenden Zwischenprodukt zu der Silizium-Vorläuferverbindung einen Wert von 0,2:0,8 bis 0,5:0,5, bevorzugt 0,3:0,7 bis 0,5:0,5, besonders bevorzugt 0,5:0,5 im Prozessgas aufweist, wobei es sich bei der Silizium-Vorläuferverbindung um Siliziumtetrachlorid und bei dem auf Silizium basierenden Zwischenprodukt um Trichlorsilan und bei dem Prozessgas um Wasserstoff handelt. Somit liegt die Silizium-Vorläuferverbindung im Überschuss oder in gleicher Menge wie das auf Silizium basierende Zwischenprodukt im Gaszustrom der Reaktionskammer vor.

Es liegt im Rahmen der Erfindung, dass das Substrat aus polykristallinem oder einkristallinem Silizium, Keramik, Glas und/oder aus deren Verbunde oder Schichtsysteme ausgebildet ist. Die Erfindung ist jedoch hierauf nicht beschränkt, denn es sind beispielsweise auch polymerhaltige Substrate oder andere Halbleitermaterialien wie z.B. Siliziumcarbid oder andere Verbindungshalbleiter denkbar.

Da bei der Herstellung von Siliziumschichten auf Substraten mittels chemischer Gasphasenabscheidung aus Chlorsilan immer weniger als 100%, typischerweise zwischen 15% und 30% der eingesetzten Silizium-Vorläuferverbindung in festes Silizium umgewandelt werden, ermöglicht die Rückführung von zumindest einem der Bestandteile des Überschusses des gasförmigen Gemisches neben einer deutlichen Reduzierung von umweltbelastenden Abfallstoffen auch die Verringerung der Prozesskosten aufgrund eines geringeren Verbrauchs der Silizium-Vorläuferverbindung.

Des Weiteren ist die Erfindung auf der Erkenntnis begründet, dass die Abscheidung von Silizium nicht nur temperaturabhängig ist, sondern auch von der molaren Zusammensetzung des gasförmigen Gemisches abhängt, welches sich aus dem zumindest einem auf Silizium basierenden Zwischenprodukt, der Silizium-Vorläuferverbindung sowie dem Prozessgas zusammensetzt. Untersuchungen des Anmelders haben ergeben, dass durch die Wahl eines geeigneten Molverhältnisses von dem auf Silizium basierenden Zwischenprodukts und der Silizium-Vorläuferverbindung die Abscheidung von Silizium gehemmt oder ganz unterbunden wird. Diese Erkenntnis ist darin begründet, dass eine chemische Gasphasenabscheidung von Silizium aus Silizium-Vorläuferverbindungen und/oder auf Silizium basierenden Zwischenprodukten tendenziell als Gleichgewichtsreaktion abläuft, welche temperatur- sowie konzentrationsabhängig verläuft. Insbesondere bei einem Molverhältnis von dem auf Silizium basierenden Zwischenprodukt und der Silizium-Vorläuferverbindung von 0,2:0,8 bis 0,5:0,5 kann die parasitäre Abscheidung größtenteils verhindert werden kann. Bei einem Molverhältnis von dem auf Silizium basierenden Zwischenprodukt und der Silizium-Vorläuferverbindung von 0,3:0,7 bis 0,5:0,5 kann die parasitäre Abscheidung sogar ganz verhindert werden. Ein derartiges Molverhältnis kann durch ein kontrolliertes Einleiten der Silizium-Vorläuferverbindung sowie Rückführen von zumindest einem der Bestandteile des Überschusses des gasförmigen Gemisches, ausgewählt aus der Silizium-Vorläuferverbindung, dem aus Silizium basierenden Zwischenprodukt und/oder dem Prozessgas in die Gaszuführung zur Reaktionskammer kontrolliert werden.

Es ist allgemein bekannt, dass die Abscheiderate von festem Silizium auf Substraten während der chemischen Gasphasenabscheidung auch von der Zusammensetzung des in die Reaktionskammer eingeleiteten Gasstroms abhängt. Um die Abscheiderate von Silizium zu optimieren, können daher im Verfahrensschritt (b) vorzugsweise nicht nur eine, sondern auch mehrere Silizium-Vorläuferverbindungen in die Abscheidekammer eingeleitet werden. Werden mehrere Silizium-Vorläuferverbindungen in die Gaszuführung zur Reaktionskammer eingeleitet, so bezieht sich das angegebene Molverhältnis auf eine der Silizium-Vorläuferverbindungen. Es liegt im Rahmen der Erfindung, dass mehrere Chlorsilane, insbesondere Siliziumtetrachlorid und Trichlorsilan, als Silizium-Vorläuferverbindungen in Verfahrensschritt (b) eingeleitet werden. In diesem Fall bezieht sich das Molverhältnis bevorzugt auf das höherwertige Chlorsilan im Verhältnis zu dem auf Silizium basierenden Zwischenprodukt.

Aufgrund der Bildung des gasförmigen Gemisches aus zumindest einem auf Silizium basierendem Zwischenprodukt, der Silizium-Vorläuferverbindung sowie dem Prozessgas in der Reaktionskammer in Verfahrensschritt (c) sowie der nachfolgenden Silizium-Abscheidung in Verfahrensschritt (d) ist die Zusammensetzung des abgeleiteten Überschusses des gasförmigen Gemisches nur ungenau vorhersagbar. Daher erfolgt in einer ersten vorteilhaften Ausgestaltung des Verfahrens in Schritt (f) eine Bestimmung des Molverhältnisses des auf Silizium basierenden Zwischenprodukts und der Silizium-Vorläuferverbindung im Überschuss des gasförmigen Gemisches durch eine Messeinheit.

Es liegt dabei im Rahmen der Erfindung, dass diese Messeinheit direkt zur Bestimmung des Molverhältnisses oder zur Bestimmung einer äquivalenten Größe, insbesondere der Konzentration und/oder der Menge und/oder des Volumen- oder Massenflusses von einem und/oder mehreren auf Silizium basierendem Zwischenprodukten ausgebildet ist, woraus sich das Molverhältnis des auf Silizium basierenden Zwischenprodukts und der Silizium-Vorläuferverbindung im Überschuss des gasförmigen Gemisches ableiten lässt. Alternativ kann die Messeinheit jedoch auch dazu dienen, das Molverhältnis des auf Silizium basierenden Zwischenprodukts und der Silizium-Vorläuferverbindung im Überschuss des gasförmigen Gemisches direkt zu bestimmen. Des Weiteren kann die Messeinheit zur Online-Bestimmung des betreffenden Molverhältnisses oder der Konzentration von einem und/oder mehreren auf Silizium basierendem Zwischenprodukte dienen. Alternativ kann die Messeinheit auch nur zeitweise zur Bestimmung des betreffenden Molverhältnisses oder der Konzentration von einem und/oder mehreren auf Silizium basierendem Zwischenprodukte dienen, beispielsweise zu Beginn der chemischen Gasphasenabscheidung und/oder nach bestimmten Zeitintervallen. Die Erfindung ist jedoch nicht hierauf beschränkt.

In einer weiteren vorteilhaften Ausgestaltung des Verfahrens wird das von der Messeinheit ermittelte Molverhältnis des auf Silizium basierenden Zwischenprodukts zu der Silizium-Vorläuferverbindung an eine Steuereinheit weitergeleitet, welche Steuereinheit das Einleiten der Silizium-Vorläuferverbindung derart steuert, dass das Molverhältnis von dem auf Silizium basierenden Zwischenprodukt zu der Silizium-Vorläuferverbindung einen Wert von 0,2:0,8 bis 0,5:0,5, bevorzugt 0,3:0,7 bis 0,5:0,5, besonders bevorzugt 0,5:0,5 im Prozessgas aufweist.

Die Weiterleitung des von der Messeinheit ermittelten Molverhältnisses kann dabei automatisch, insbesondere per Datenleitung oder drahtlos, oder händisch durch einen Benutzer erfolgen, welcher das Ergebnis der Messeinheit abliest und diese Information an die Steuereinheit übermittelt. Das nachfolgende Einleiten der Silizium-Vorläuferverbindung durch die Steuereinheit kann ebenfalls automatisch oder händisch durch den Benutzer erfolgen. Hierbei liegt es im Rahmen der Erfindung, dass die Steuereinheit als Durchfluss-Regler ausgebildet ist. Die Erfindung ist jedoch nicht hierauf beschränkt. Die automatische Regelung weist jedoch erhebliche Vorteile hinsichtlich der Prozesssicherheit und eines reduzierten Arbeitsaufwands auf.

Um die chemische Gasphasenabscheidung von festem Silizium auf einem Substrat als kontinuierlichen Prozess durchführen zu können, spielt nicht nur das Molverhältnis von dem auf Silizium basierenden Zwischenprodukt zu der Silizium-Vorläuferverbindung im Gaszustrom der Reaktionskammer eine wesentliche Rolle, sondern auch die Gesamtmenge der Silizium-Vorläuferverbindung und des auf Silizium basierenden Zwischenprodukts. Ein Absinken der Gesamtmenge unter einen spezifischen Wert führt zu einem Abfallen der Abscheiderate von festem Silizium. Grund hierfür ist, dass die Siliziumabscheidung als Gleichgewichtsreaktion abläuft. Es ist daher vorteilhaft, dass diese Gesamtmenge beim Einleiten in die Reaktionskammer konstant gehalten wird, um optimale Bedingungen für die Abscheidung vom festem Silizium zu schaffen. Dies wird vorteilhafterweise dadurch erreicht, dass der Zustrom an Prozessgas bevorzugt konstant gehalten wird, während das auf Silizium basierende Zwischenprodukt und die Silizium-Vorläuferverbindung derart zudosiert werden, dass zum einen das gewünschte Molverhältnis beider Verbindungen zueinander eingestellt wird und zum anderen die gewünschte Gesamtmenge beider Verbindungen erreicht wird. Wird beispielsweise durch die Messeinheit eine zu hohe Menge des auf Silizium basierenden Zwischenprodukts detektiert, so kann dieses Zwischenprodukt auch aus der Vorrichtung abgeführt werden, um eine maximale Gesamtmenge in der Reaktionskammer nicht zu überschreiten.

Des Weiteren sieht eine vorteilhafte Ausgestaltung des erfindungsgemäßen Verfahrens vor, dass der Überschuss des gasförmigen Gemischs in Schritt (f) von Verunreinigungen befreit wird. Um weiterhin in Schritt (f) des Verfahrens die Rückführung von einer oder mehrerer Bestandteile des Überschusses des gasförmigen Gemisches zu ermöglichen, kann das Verfahren in einer bevorzugten Ausgestaltung in Schritt (f) eine Rückgewinnungseinheit vorsehen, welche den Überschuss des gasförmigen Gemischs zumindest teilweise auftrennt. Eine derartige Rückgewinnungseinheit ermöglicht dadurch nicht nur das Rückführen eines gewünschten Bestandteils des Überschusses des gasförmigen Gemischs, sondern auch die Abtrennung von unerwünschten Nebenprodukten der Silizium-Abscheidung.

In einer weiteren bevorzugten Ausführungsform des Verfahrens wird in Schritt (f) das auf Silizium basierende Zwischenprodukt und/oder die Silizium-Vorläuferverbindung und/oder das Prozessgas in die Reaktionskammer rückgeführt.

Erfindungsgemäß handelt es sich bei der Silizium-Vorläuferverbindung um ein Chlorsilan, vorliegend um Siliziumtetrachlorid.

Wie bereits zuvor erläutert, kann die Abscheiderate von Silizium vorzugsweise dadurch optimiert werden, dass in Verfahrensschritt (b) nicht nur eine, sondern auch mehrere Silizium-Vorläuferverbindungen in die Abscheidekammer eingeleitet werden. Werden mehrere Silizium-Vorläuferverbindungen in die Reaktionskammer eingeleitet, so handelt es sich bei den Silizium-Vorläuferverbindungen bevorzugt um Siliziumtetrachlorid und Trichlorsilan.

Im Vergleich zu anderen kommerziell erhältlichen Silanen wie beispielsweise Disilan oder Trisilan sind Chlorsilane deutlich günstiger und weniger gefährlich in der Handhabung, denn sie zeigen u.a. keine Selbstentzündung in Gegenwart von Luftsauerstoff. Zudem ermöglicht die Verwendung von Chlorsilanen eine deutlich höhere Abscheiderate zur Erzielung einer hohen Schichtqualität im Vergleich zu den genannten Silanen, wodurch der Durchsatz an mit Silizium beschichteten Substraten deutlich gesteigert wird.

Es ist allgemein bekannt, dass unter Verwendung von Trichlorsilan als Vorläuferverbindung hohe Abscheideraten von Silizium im Bereich von 1 µm/min bis 15 µm/min auf Substraten erreicht werden kann, wobei es zur Abscheidung von Silizium bereits bei Temperaturen ab 700 °C kommt. Nachteilig hierbei ist jedoch, dass es bei diesen oder höheren Temperaturen zu einer deutlichen Erhöhung von parasitären Abscheidungen in den Gasleitungen der Reaktionskammer kommt. Im Gegensatz hierzu ist reines Siliziumtetrachlorid stabil bis ca. 1600 °C. Aufgrund des niedrigeren Silizium zu Chlor Verhältnis ist jedoch die Abscheiderate deutlich geringer.

Untersuchungen des Anmelders haben ergeben, dass die Verwendung von Siliziumtetrachlorid in Gegenwart von Trichlorsilan zu einer optimierten Abscheiderate bei gleichzeitiger Vermeidung von parasitären Abscheidungen führt.

Da Siliziumtetrachlorid bei zu einer Temperatur von 1600 °C thermisch stabil ist und die Siliziumabscheidung bei niedrigeren Temperaturen nur in Gegenwart von Wasserstoff abläuft, ist es erfindungsgemäß vorgesehen, dass es sich bei dem Prozessgas um Wasserstoff handelt.

Erfindungsgemäß ist vorgesehen, dass es sich bei dem auf Silizium basierenden Zwischenprodukt um ein Chlorsilan handelt, vorliegend um Trichlorsilan.

Wie bereits zuvor erläutert, können in Verfahrensschritt (b) vorteilhafterweise mehrere Silizium-Vorläuferverbindungen in die Reaktionskammer eingeleitet werden, wobei es sich bei den Silizium-Vorläuferverbindungen bevorzugt um Siliziumtetrachlorid und Trichlorsilan handelt. Es sei darauf hingewiesen, dass in diesem Fall Trichlorsilan zum einen als Silizium-Vorläuferverbindung in die Reaktionskammer eingeleitet wird und zum anderen auch als Zwischenprodukt in Verfahrensschritt (f) in die Reaktionskammer rückgeführt werden kann.

Um eine optimale Abscheidung von Silizium auf dem Substrat zu erreichen und gleichzeitig die Prozesskosten zu minimieren, sieht eine vorteilhafte Ausgestaltung des Verfahrens vor, dass eine Gesamtmenge an auf Silizium basierender Vorläuferverbindung und auf Silizium basierendem Zwischenprodukt in Schritt (c) in einem Stoffmengenverhältnis von 1 bis 10 mol%, bevorzugt 2 bis 7 mol%, besonders bevorzugt 3 bis 6 mol%, in dem Prozessgas vorliegt.

Eine weitere vorteilhafte Ausgestaltung des Verfahrens sieht vor, dass die Bildung einer Siliziumschicht durch chemische Gasphasenabscheidung von Silizium aus der auf Silizium-Vorläuferverbindung und/oder dem auf Silizium basierenden Zwischenprodukt auf dem Substrat bei einem Druck von 0,8 bar bis 1,2 bar in der Reaktionskammer stattfindet.

Es liegt daher im Rahmen der Erfindung, dass das erfindungsgemäße Verfahren bei annähernd Atmosphärendruck durchgeführt wird. Hierdurch wird eine zeitintensive Überführung der Reaktionskammer ins Vakuum vermieden, wodurch der Durchsatz an mit Silizium beschichteter Substrate deutlich gesteigert werden kann.

Da die Abscheiderate von Silizium auf dem Substrat stark temperaturabhängig ist, wird zumindest das Substrat in der Reaktionskammer in einer weiteren vorteilhaften Ausgestaltung des erfindungsgemäßen Verfahrens auf eine Temperatur von 700 °C bis 1400 °C, vorzugsweise auf 1000 °C bis 1300 °C, besonders bevorzugt auf 1100 °C bis 1200 °C aufgeheizt. Somit ermöglicht das Aufheizen des Substrats auf eine bestimmte Temperatur, die Abscheiderate an Silizium auf dem Substrat gezielt zu einzustellen.

Es liegt im Rahmen der Erfindung, dass nicht nur das Substrat, sondern auch die Reaktionskammer und/oder die an der Reaktionskammer angeordneten Gasleitungen aufgeheizt werden. Dabei können das Substrat und/oder die Reaktionskammer und/oder die Gasleitungen jeweils auf unterschiedliche Temperaturen aufgeheizt werden. Hierdurch wird eine optimale Gaszufuhr zur Reaktionskammer sowie eine Gasrückfuhr ermöglicht.

Ein weiterer Aspekt der vorliegenden Erfindung ist eine Vorrichtung zur kontinuierlichen Gasphasenabscheidung von Silizium auf Substraten, insbesondere zur Durchführung eines Verfahrens nach einem der Ansprüche 1 bis 8, aufweisend: Eine Reaktionskammer, welche Reaktionskammer zumindest eine Einlassöffnung und eine zumindest eine Auslassöffnung für Substrate umfasst, eine Transporteinrichtung zum Transport der Substrate von der Einlassöffnung zu der Auslassöffnung durch die Reaktionskammer, zumindest zwei Gaseinlässe zur Zuführung eines Gases in die Reaktionskammer, zumindest ein Gasauslass zur Abfuhr des Gases aus der Reaktionskammer, zumindest zwei Fluidzufuhrleitungen, vorzugsweise Gaszufuhrleitungen, welche Fluidzufuhrleitungen mit zwei der Gaseinlässe der Reaktionskammer verbunden sind.

Die Gaseinlässe dienen dazu, das Prozessgas, das auf Silizium basierende Zwischenprodukt und/oder die Silizium-Vorläuferverbindung der Reaktionskammer zuzuführen.

Wesentlich dabei ist, dass die erfindungsgemäße Vorrichtung zumindest eine Steuereinheit aufweist sowie dass zwischen dem Gasauslass und dem Gaseinlass der Reaktionskammer eine Kreislaufleitung angeordnet ist, welche Kreislaufleitung mit der Fluidzufuhrleitung sowie dem Gasauslass der Reaktionskammer verbunden ist, wobei die Vorrichtung zumindest eine Messeinheit zur Bestimmung eines Molverhältnisses des auf Silizium basierenden Zwischenprodukts und der Silizium Vorläuferverbindung und/oder einer hierzu äquivalenten Größe aufweist und wobei die Steuereinheit und die Messeinheit derart zusammenwirkend ausgebildet sind, dass ein Durchfluss der Zufuhrleitungen durch die Steuereinheit aufgrund eines von der Messeinheit an die Steuereinheit übermittelten Signals steuer- oder regelbar ist, wobei das Molverhältnis von dem auf Silizium basierenden Zwischenprodukt zu der Silizium-Vorläuferverbindung einen Wert von 0,2:0,8 bis 0,5:0,5, bevorzugt 0,3:0,7 bis 0,5:0,5, besonders bevorzugt 0,5:0,5 im Prozessgas aufweist, wobei es sich bei der Silizium-Vorläuferverbindung um Siliziumtetrachlorid und bei dem auf Silizium basierenden Zwischenprodukt um Trichlorsilan und bei dem Prozessgas um Wasserstoff handelt.

Wie bereits zuvor erwähnt, liegt es dabei im Rahmen der Erfindung, dass die Messeinheit zur Bestimmung der Konzentration und/oder der Menge und/oder des Volumen- oder Massenflusses von einem und/oder mehreren auf Silizium basierendem Zwischenprodukten ausgebildet ist, woraus sich das Molverhältnis des auf Silizium basierenden Zwischenprodukts und der Silizium-Vorläuferverbindung im Überschuss des gasförmigen Gemisches ableiten lässt. Alternativ kann die Messeinheit jedoch auch dazu dienen, das Molverhältnis des auf Silizium basierenden Zwischenprodukts und der Silizium-Vorläuferverbindung im Überschuss des gasförmigen Gemisches direkt zu bestimmen. Des Weiteren ist die Messeinheit zur Online-Bestimmung des betreffenden Molverhältnisses oder der Konzentration von einem und/oder mehreren auf Silizium basierendem Zwischenprodukte ausgebildet. Alternativ kann die Messeinheit auch nur zeitweise zur Bestimmung des betreffenden Molverhältnisses oder der Konzentration von einem und/oder mehreren auf Silizium basierendem Zwischenprodukte dienen, beispielsweise zu Beginn der chemischen Gasphasenabscheidung und/oder nach bestimmten Zeitintervallen. Die Erfindung ist jedoch nicht hierauf beschränkt. Die automatische Regelung weist jedoch erhebliche Vorteile hinsichtlich der Prozesssicherheit und eines reduzierten Arbeitsaufwands auf.

Eine derartige Vorrichtung ermöglicht den kontinuierlichen Transport von Substraten in die Reaktionskammer, wobei die Substrate mittels der Transporteinrichtung von der Einlassöffnung der Reaktionskammer zu der Auslassöffnung transportiert werden. Die Gaseinlässe der erfindungsgemäßen Vorrichtungen dienen dabei zum Einleiten des Prozessgases, der Silizium-Vorläuferverbindung sowie für rückgeführte Bestandteile des Überschusses der gasförmigen Vorläuferverbindungen nach deren Ausleiten aus der Reaktionskammer.

Eine erste bevorzugte Ausgestaltung der erfindungsgemäßen Vorrichtung besteht darin, dass die Messeinheit an der Kreislaufleitung angeordnet ist.

Es liegt im Rahmen der Erfindung, dass die Messeinheit entweder in die Kreislaufleitung integriert oder an der Kreislaufleitung angeordnet ist. Ist die Messeinheit in die Kreislaufleitung integriert, erfolgt die Bestimmung des Molverhältnisses des auf Silizium basierenden Zwischenprodukts und der Silizium-Vorläuferverbindung online. Diese Messung kann kontinuierlich oder in vom Benutzer voreingestellten Zeitintervallen erfolgen. Ist die Messeinheit an der Kreislaufleitung angeordnet, so erfolgt die Messung des Molverhältnisses des auf Silizium basierenden Zwischenprodukts und der Silizium-Vorläuferverbindung entweder durch automatisches Zuführen einer Probe oder nach Probenentnahme durch den Benutzer, welcher die Probe dem des Überschusses des gasförmigen Gemisches der Messeinheit manuell zuführt. Die Erfindung ist jedoch nicht hierauf beschränkt.

Eine weitere bevorzugte Ausgestaltung der erfindungsgemäßen Vorrichtung sieht vor, dass die Messeinheit als Spektrometer oder als Massendurchflussmesser, beispielsweise als Coriolis-Massendurchflussmesser, oder als Volumen-Durchflussmesser ausgebildet ist.

Wird eine bei Raumtemperatur flüssige Silizium-Vorläuferverbindung und/oder ein bei Raumtemperatur flüssiges auf Silizium basierendes Zwischenprodukt verwendet, so weist in einer vorteilhaften Ausgestaltung der Vorrichtung zumindest eine der Fluidzufuhrleitungen einen Verdampfer auf, welcher Verdampfer die auf Silizium-Vorläuferverbindung und/oder das auf Silizium basierende Zwischenprodukt in den gasförmigen Zustand überführt.

Eine weitere bevorzugte Ausgestaltung der erfindungsgemäßen Vorrichtung besteht darin, dass die Kreislaufleitung eine Rückgewinnungseinheit aufweist, welche Rückgewinnungseinheit zur Auftrennung des aus der Reaktionskammer ausgeleiteten Überschusses des gasförmigen Gemisches und Zurückgewinnung der Silizium-Vorläuferverbindung und/oder des auf Silizium basierenden Zwischenprodukts und/oder des Prozessgases dient.

In einer weiteren vorteilhaften Ausgestaltung der erfindungsgemäßen Vorrichtung ist diese Rückgewinnungseinheit als destillative Trennapparatur und/oder Trockenabsorber oder -adsorber ausgebildet. Mittels des Trockenabsorbers bzw. -adsorbers kann der der bei der chemischen Gasphasenabscheidung von festem Silizium gebildete Chlorwasserstoff und/oder die Silizium-Vorläuferverbindung bei der Rückführung des Überschusses des gasförmigen Gemischs abgetrennt werden.

Vorteilhafterweise werden Bestandteile des gasförmigen Überschusses separat rückgeführt, da hierdurch eine separate Regelung und/oder Verwertung möglich ist. Um die Silizium-Vorläuferverbindung und/oder das auf Silizium basierende Zwischenprodukt und/oder des Prozessgas nach deren Auftrennung durch beispielsweise eine destillative Trennapparatur separat rückzuführen, weist die Kreislaufleitung bevorzugt zwischen der Rückgewinnungseinheit und der Fluidzufuhrleitung mehrere Teilleitungen auf, welche Teilleitungen zum separaten Rückführen des Prozessgases, des auf Silizium basierenden Zwischenprodukts und/oder der Silizium-Vorläuferverbindung dienen, wobei jede Teilleitung eine separate Messeinheit zur Bestimmung des Massenflusses und/oder Volumenflusses des Prozessgases, des auf Silizium basierenden Zwischenprodukts und/oder der Silizium-Vorläuferverbindung aufweist.

Es liegt im Rahmen der Erfindung, dass das Prozessgas und/oder das auf Silizium basierende Zwischenprodukt und/oder die Silizium-Vorläuferverbindung nach deren Auftrennung aus der Vorrichtung abgeführt werden. Hierfür kann beispielsweise der Gaswäscher und/oder die destillative Trennapparatur einen Gasauslass, welcher mit einer Gasausfuhrleitung verbunden ist, aufweisen. Die Erfindung ist jedoch nicht hierauf beschränkt, denn ein derartiger Gasauslass mit Gasausfuhrleitung kann auch an der Kreislaufleitung im Bereich der Messeinheit angeordnet sein. Es ist jedoch vorteilhaft, zumindest die Bestandteile des auf Silizium basierenden Zwischenprodukts rückzuführen, um die Prozesskosten zu senken. Ebenso ist es aus diesem Grund vorteilhaft, das Prozessgas, insbesondere den Wasserstoff, rückzuführen.

Der Gegenstand der Anmeldung bezieht sich ferner auf die folgenden weiteren Ausführungsbeispiele:
Beispiel 1. Verfahren zur kontinuierlichen Gasphasenabscheidung von Silizium auf Substraten, welches die folgenden Schritte aufweist:
   (a) Einbringen von zumindest einem Substrat in eine Reaktionskammer;
   (b) Einleiten eines Prozessgases sowie zumindest einer gasförmigen Silizium-Vorläuferverbindung in die Reaktionskammer;
   (c) Bildung eines gasförmigen Gemisches aus zumindest einem auf Silizium basierenden Zwischenprodukt in Koexistenz mit der gasförmigen Silizium-Vorläuferverbindung und dem Prozessgas in der Reaktionskammer;
   (d) Bildung einer Siliziumschicht durch Gasphasenabscheidung von Silizium aus der gasförmigen Silizium-Vorläuferverbindung und/oder des auf Silizium basierenden Zwischenprodukts auf dem Substrat;
   (e) Abführen eines Überschusses des gasförmigen Gemisches aus der Reaktionskammer;
      dadurch gekennzeichnet, dass das Verfahren weiterhin einen Schritt (f) aufweist, bei dem zumindest einer der Bestandteile des Überschusses des gasförmigen Gemisches, ausgewählt aus der Silizium-Vorläuferverbindung, dem auf Silizium basierenden Zwischenprodukt und/oder dem Prozessgas, in die Reaktionskammer rückgeführt wird, wobei in dem Verfahren das Einleiten der gasförmigen Silizium-Vorläuferverbindung in die Reaktionskammer derart geregelt wird, dass das Molverhältnis von dem auf Silizium basierenden Zwischenprodukt zu der Silizium-Vorläuferverbindung einen Wert von 0,2:0,8 bis 0,5:0,5, bevorzugt 0,3:0,7 bis 0,5:0,5, besonders bevorzugt 0,5:0,5 im Prozessgas aufweist.
Beispiel 2. Verfahren nach Beispiel 1, dadurch gekennzeichnet, dass in Schritt (f) das Molverhältnis des auf Silizium basierenden Zwischenprodukts und der Silizium-Vorläuferverbindung im Überschuss des gasförmigen Gemisches durch eine Messeinheit bestimmt wird.
Beispiel 3. Verfahren nach Beispiel 2, dadurch gekennzeichnet, dass das von der Messeinheit ermittelte Molverhältnis des auf Silizium basierenden Zwischenprodukts zu der Silizium-Vorläuferverbindung an eine Steuereinheit weitergeleitet wird, welche Steuereinheit das Einleiten der Silizium-Vorläuferverbindung derart regelt, dass das Molverhältnis von dem auf Silizium basierenden Zwischenprodukt zu der Silizium-Vorläuferverbindung einen Wert von 0,2:0,8 bis 0,5:0,5, bevorzugt 0,3:0,7 bis 0,5:0,5, besonders bevorzugt 0,5:0,5 im Prozessgas aufweist.
Beispiel 4. Verfahren nach einem der Beispiele 1 bis 3, dadurch gekennzeichnet, dass in Schritt (f) der Überschuss des gasförmigen Gemischs von Verunreinigungen befreit und/oder zumindest teilweise durch eine Rückgewinnungseinheit aufgetrennt wird.
Beispiel 5. Verfahren nach Beispiel 4, dadurch gekennzeichnet, dass in Schritt (f) das auf Silizium basierende Zwischenprodukt und/oder die Silizium-Vorläuferverbindung und/oder das Prozessgas über die Kreislaufleitung in die Reaktionskammer rückgeführt werden.
Beispiel 6. Verfahren nach einem der Beispiele 1 bis 5, dadurch gekennzeichnet, dass es sich bei der Silizium-Vorläuferverbindung um ein Chlorsilan handelt, vorzugsweise um Siliziumtetrachlorid und/oder Trichlorsilan.
Beispiel 7. Verfahren nach einem der Beispiele 1 bis 6, dadurch gekennzeichnet, dass es sich bei dem Prozessgas um Wasserstoff handelt.
Beispiel 8. Verfahren nach einem der Beispiele 1 bis 7, dadurch gekennzeichnet, dass es sich bei dem auf Silizium basierenden Zwischenprodukt um ein Chlorsilan handelt, vorzugsweise Trichlorsilan und/oder Dichlorsilan.
Beispiel 9. Verfahren nach einem der Beispiele 1 bis 8, dadurch gekennzeichnet, dass eine Gesamtmenge an der Silizium-Vorläuferverbindung und der auf Silizium basierendem Zwischenprodukt in Schritt (c) in einem Stoffmengenverhältnis von 1 bis 10 mol%, bevorzugt 2 bis 7 mol%, besonders bevorzugt 3 bis 6 mol%, in dem Prozessgas vorliegt.
Beispiel 10. Verfahren nach einem der Beispiele 1 bis 9, dadurch gekennzeichnet, dass die Bildung einer Siliziumschicht durch Gasphasenabscheidung von Silizium aus der Silizium-Vorläuferverbindung und/oder dem auf Silizium basierenden Zwischenprodukt auf dem Substrat bei einem Druck von 0,8 bis 1,2 bar in der Reaktionskammer stattfindet.
Beispiel 11. Verfahren nach einem der Beispiele 1 bis 10, dadurch gekennzeichnet,dass zumindest das Substrat in der Reaktionskammer auf eine Temperatur von 700 °C bis 1400 °C, vorzugsweise auf 1000 °C bis 1300 °C, besonders bevorzugt auf 1100 °C bis 1200 °C aufgeheizt wird.
Beispiel 12. Vorrichtung zur kontinuierlichen Gasphasenabscheidung von Silizium auf Substraten, insbesondere zur Durchführung eines Verfahrens nach einem der Beispiele 1 bis 11, aufweisend:
   - eine Reaktionskammer, welche Reaktionskammer zumindest eine Einlassöffnung und eine zumindest eine Auslassöffnung für Substrate umfasst;
   - eine Transporteinrichtung zum Transport der Substrate von der Einlassöffnung zu der Auslassöffnung durch die Reaktionskammer;
   - zumindest zwei Gaseinlässe zur Zuführung eines Gases in die Reaktionskammer;
   - zumindest ein Gasauslass zur Abfuhr des Gases aus der Reaktionskammer;
   - zumindest zwei Fluidzufuhrleitungen, vorzugsweise Gaszufuhrleitungen, welche Fluidzufuhrleitungen mit zwei der Gaseinlässe der Reaktionskammer verbunden sind;
   dadurch gekennzeichnet, dass die Vorrichtung zumindest eine Steuereinheit aufweist sowie dass zwischen dem Gasauslass und dem Gaseinlass der Reaktionskammer zumindest eine Kreislaufleitung angeordnet ist, welche Kreislaufleitung mit der Fluidzufuhrleitung sowie dem Gasauslass der Reaktionskammer verbunden ist, wobei die Vorrichtung zumindest eine Messeinheit zur Bestimmung eines Molverhältnisses des auf Silizium basierende Zwischenprodukts und der Silizium-Vorläuferverbindung und/oder einer hierzu äquivalenten Größe aufweist und wobei die Steuereinheit und die Messeinheit derart zusammenwirkend ausgebildet sind, dass ein Durchfluss der Zufuhrleitungen durch die Steuereinheit aufgrund eines von der Messeinheit an die Steuereinheit übermittelten Signals steuer- oder regelbar ist.
Beispiel 13. Vorrichtung nach Beispiel 12, dadurch gekennzeichnet, dass die Messeinheit an der Kreislaufleitung angeordnet ist.
Beispiel 14. Vorrichtung nach Beispiel 12 oder 13, dadurch gekennzeichnet, dass die Messeinheit als Spektrometer, als Massendurchflussmesser oder als Volumendurchflussmesser ausgebildet ist.
Beispiel 15. Vorrichtung nach einem der Beispiele 12 bis 14, dadurch gekennzeichnet, dass der zumindest eine der Fluidzufuhrleitungen einen Verdampfer aufweist, welcher zur Überführung der Silizium-Vorläuferverbindung und/oder des auf Silizium basierenden Zwischenprodukts in den gasförmigen Zustand dient.
Beispiel 16. Vorrichtung nach einem der Beispiele 12 bis 15, dadurch gekennzeichnet, dass die Kreislaufleitung einen Gaswäscher und/oder eine Rückgewinnungseinheit aufweist, wobei vorzugsweise die Rückgewinnungseinheit als destillative Trennapparatur ausgebildet ist und/oder einen Trockenabsorber oder -adsorber aufweist.
Beispiel 17. Vorrichtung nach einem der Beispiele 12 bis 16, dadurch gekennzeichnet, dass die Kreislaufleitung zwischen der Rückgewinnungseinheit und der Fluidzufuhrleitung mehrere Teilleitungen aufweist, welche Teilleitungen zum separaten Rückführen des Prozessgases, des auf Silizium basierenden Zwischenprodukts und/oder der Silizium-Vorläuferverbindung dienen, wobei jede Teilleitung eine separate Messeinheit zur Bestimmung des Massenflusses und/oder Volumenflusses des Prozessgases, des auf Silizium basierenden Zwischenprodukts und/oder der Silizium-Vorläuferverbindung aufweist.

Weitere vorteilhafte Eigenschaften der Erfindung ergeben sich aus der nachfolgenden Beschreibung von Ausführungsbeispielen anhand der Zeichnung. Dabei zeigt
- Figur 1: eine schematische Darstellung eines ersten Ausführungsbeispiels einer erfindungsgemäßen Vorrichtung zur kontinuierlichen Gasphasenabscheidung von Silizium auf Substraten,
- Figur 2: eine schematische Darstellung eines zweiten Ausführungsbeispiels einer erfindungsgemäßen Vorrichtung zur kontinuierlichen Gasphasenabscheidung von Silizium auf Substraten und
- Figur 3: eine schematische Darstellung eines dritten Ausführungsbeispiels einer erfindungsgemäßen Vorrichtung zur kontinuierlichen Gasphasenabscheidung von Silizium auf Substraten.

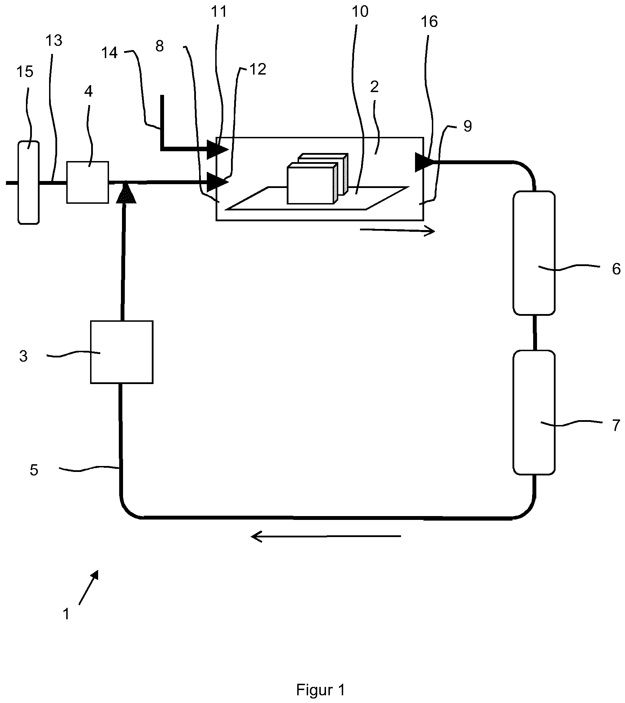

Figur 1 zeigt ein erstes Ausführungsbeispiel einer erfindungsgemäßen Vorrichtung 1 zur kontinuierlichen Gasphasenabscheidung von Silizium auf Substraten. Diese Vorrichtung 1 weist eine Reaktionskammer 2, eine Messeinheit 3, eine Steuereinheit 4, eine Kreislaufleitung 5, einen Gaswäscher 6 sowie eine Rückgewinnungseinheit 7 auf.

Die Reaktionskammer 2 weist eine Einlassöffnung 8 auf, worüber zu beschichtende Substrate in die Reaktionskammer 2 eingebracht werden können. Weiterhin befindet sich auf der der Einlassöffnung 8 gegenüberliegenden Seite der Reaktionskammer 2 eine Auslassöffnung 9, über welche Auslassöffnung 9 mit Silizium beschichtete Substrate aus der Reaktionskammer 2 herausgeführt werden können. Der Transport der Substrate in die Reaktionskammer 2 hinein und wieder hinaus erfolgt mittels einer Transporteinrichtung 10. Wie in Figur 1 durch einen Pfeil gekennzeichnet ist, weist die Transporteinrichtung 10 eine Transportrichtung der Substrate von der Einlassöffnung 8 zur Auslassöffnung 9 auf. Die Transporteinrichtung 10 kann als Förderband ausgebildet sein. Alternativ kann die Transporteinrichtung 10 auch mehrere Transportrollen aufweisen, oder als Gleitschienentransport ausgebildet sein.

Wie in Figur 1 dargestellt, können jeweils zwei Substrate senkrecht aufgestellt in die Reaktionskammer 2 mittels der Transporteinrichtung 10 eingebracht werden. Dabei sind die Substrate zueinander parallel angeordnet, so dass die zu beschichtenden Seiten der Substrate einander gegenüberstehen. Des Weiteren weist im vorliegenden Ausführungsbeispiel die Reaktionskammer 2 eine Temperatur von 1100 °C auf.

Zum Einleiten einer gasförmigen Silizium-Vorläuferverbindung und eines Prozessgases sind an der Reaktionskammer 2 im Bereich der Einlassöffnung 8 zwei Gaseinlässe 11, 12 angeordnet, über welche die gasförmigen Silizium-Vorläuferverbindung und das Prozessgases getrennt voneinander in die Reaktionskammer eingeleitet werden können. Im vorliegenden Ausführungsbeispiel wird als Prozessgas hochreiner Wasserstoff verwendet. Durch ein separates Einleiten der gasförmigen Silizium-Vorläuferverbindung und des Prozessgases kann die Bildung von parasitären Abscheidungen in den Gaseinlässen 11, 12 verhindert werden.

Des Weiteren sind die Gaseinlässe 11, 12 mit jeweils einer Fluidzufuhrleitung 13, 14 verbunden, worüber die Silizium-Vorläuferverbindung und das Prozessgas den Gaseinlässen 11, 12 zugeführt werden können. Im vorliegenden Ausführungsbeispiel wird Siliziumtetrachlorid als Silizium-Vorläuferverbindung verwendet. Da Siliziumtetrachlorid einen Siedepunkt von 57,6 °C aufweist und somit bei Raumtemperatur flüssig ist, ist an der Fluidzufuhrleitung 13 ein Verdampfer 15 angeordnet. Mittels der Verdampfers 15 wird flüssiges Siliziumtetrachlorid in den gasförmigen Aggregatzustand überführt, bevor es in die Reaktionskammer 2 eingeleitet wird.

Um nach Beschichtung der Substrate mit Silizium den Überschuss des Gasgemischs aus der überschüssigen Silizium-Vorläuferverbindung, dem auf Silizium basierenden Zwischenprodukt und des Prozessgases aus der Reaktionskammer 2 abführen zu können, weist die Reaktionskammer 2 im Bereich der Auslassöffnung 9 einen Gasauslass 16 auf. Der Gasauslass 16 ist mit der Kreislaufleitung 5 verbunden, welche zur Rückfuhr von zumindest einem der Bestandteile des Überschusses des gasförmigen Gemisches, ausgewählt aus der Silizium-Vorläuferverbindung, dem auf Silizium basierenden Zwischenprodukt und/oder dem Prozessgas, in die Reaktionskammer 2 dient. Des Weiteren ist die Kreislaufleitung 5 mit der Fluidzufuhrleitung 13 verbunden.

Im vorliegenden Ausführungsbeispiel sind an der Kreislaufleitung 5 der Gaswäscher 6, die Rückgewinnungseinheit 7 sowie die Messeinheit 3 angeordnet, welche über die durchgehende Kreislaufleitung 5 miteinander verbunden sind und zwar von der Seite des Gasauslasses 16 zur Seite der Fluidzufuhrleitung 13.

Der Gaswäscher 6 dient zur Aufkonzentration des abgeführten Überschusses des gasförmigen Gemisches aus der Reaktionskammer, indem im Gaswäscher 6 der abgeführte gasförmige Überschuss mit einer Waschflüssigkeit in Kontakt gebracht wird, wodurch verwertbare Bestandteile des Überschusses in der Waschflüssigkeit aufgenommen werden können. Bei den übergehenden Bestandteilen kann es sich um feste, flüssige oder gasförmige Stoffe handeln. Als Waschflüssigkeit kann beispielsweise Chlorsilan verwendet werden.

Der aufgereinigte Überschuss des gasförmigen Gemisches kann über die Kreislaufleitung 5 in die Rückgewinnungseinheit 7 geleitet werden. Im vorliegenden Ausführungsbeispiel ist die Rückgewinnungseinheit 7 als destillative Trennapparatur ausgebildet. Sie dient zur Abtrennung der Silizium-Vorläuferverbindung und/oder dem auf Silizium basierenden Zwischenprodukt vom Prozessgas. Zudem ermöglicht die Rückgewinnungseinheit 7 die Abtrennung von unerwünschten Nebenprodukten der chemischen Gasphasenabscheidung aus der Kreislaufleitung 5.

Zur Bestimmung eines Molverhältnisses des auf Silizium basierenden Zwischenprodukts und der Silizium-Vorläuferverbindung ist an der Kreislaufleitung 5 die Messeinheit 3 angeordnet. Im vorliegenden Beispiel ist die Messeinheit 3 als Infrarotspektrometer ausgebildet, welcher eine Konzentration an dem auf Silizium basierenden Zwischenprodukt und der Silizium-Vorläuferverbindung im Gasstrom der Kreislaufleitung 5 misst und dadurch das Molverhältnisses des auf Silizium basierende Zwischenprodukts und der Silizium-Vorläuferverbindung bestimmt. Alternativ kann die Messeinheit 3 jedoch auch als Coriolis-Massendurchflussmesser ausgebildet sein. Die Erfindung ist jedoch nicht hierauf beschränkt.

Um die Zufuhr der Silizium-Vorläuferverbindung in die Reaktionskammer 2 zu regulieren, ist an der Fluidzufuhrleitung 13 eine Steuereinheit 4 angeordnet, welche beispielsweise als Gasdurchflussregler ausgebildet sein kann. Die Steuereinheit 4 dient zudem dazu, das Molverhältnis von dem auf Silizium basierenden Zwischenprodukt zu der Silizium-Vorläuferverbindung in der Reaktionskammer 2 beim Einleiten zu steuern. Hierfür ist die Steuereinheit 4 mit der Messeinheit 3 verbunden.

Ein von der Messeinheit 3 bestimmtes Molverhältnis von dem auf Silizium basierenden Zwischenprodukt zu der Silizium-Vorläuferverbindung in dem Überschuss des gasförmigen Gemischs in der Kreislaufleitung 5 wird an die Steuereinheit 4 weitergeleitet. Um ein gewünschtes Molverhältnis von dem auf Silizium basierenden Zwischenprodukt zu der Silizium-Vorläuferverbindung von 0,2:0,8 bis 0,5:0,5, bevorzugt 0,3:0,7 bis 0,5:0,5, besonders bevorzugt 0,5:0,5 im Prozessgas in der Reaktionskammer 2 zu erhalten, steuert die Steuereinheit 4 anhand des von der Messeinheit 3 bestimmten Molverhältnisses von dem auf Silizium basierenden Zwischenprodukt zu der Silizium-Vorläuferverbindung in dem Überschuss des gasförmigen Gemischs in der Kreislaufleitung 5 die Menge an zugeführter Silizium-Vorläuferverbindung über die Fluidzufuhrleitung 13 und den Gaseinlass 12 in die Reaktionskammer. Im vorliegenden Ausführungsbeispiel sind die Steuereinheit 4 und die Messeinheit 3 elektrisch leitend miteinander verbunden, wodurch die Messwerte der Messeinheit 3 automatisch an die Steuereinheit 4 übermittelt werden. Es liegt jedoch auch im Rahmen der Erfindung, dass ein Benutzer der Vorrichtung 1 das von der Messeinheit 3 ermittelte Molverhältnis abliest und manuell an die Steuereinheit 4 übermittelt.

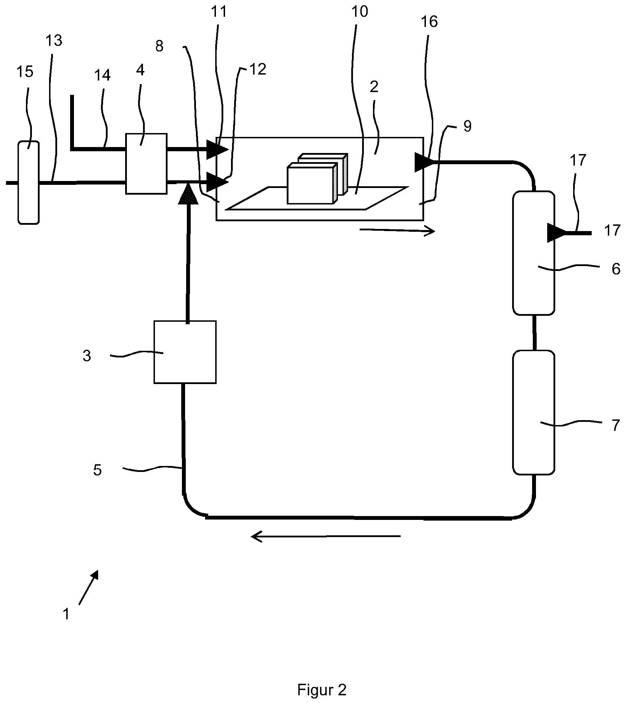

Figur 2 zeigt ein zweites Ausführungsbeispiel einer erfindungsgemäßen Vorrichtung 1 zur kontinuierlichen Gasphasenabscheidung von Silizium auf Substraten. Die Vorrichtung 1 weist einen weitgehend zu der in Figur 1 beschriebenen Ausgestaltung identischen Aufbau auf, weshalb auf weitere Einzelheiten zunächst nicht einzugehen ist.

Um die Zufuhr der Silizium-Vorläuferverbindung und des Prozessgases in die Reaktionskammer 2 zu regulieren, ist an den Fluidzufuhrleitung 13, 14 die Steuereinheit 4 angeordnet. Die Steuereinheit 4 dient zum einen dazu, das Molverhältnis von dem auf Silizium basierenden Zwischenprodukt zu der Silizium-Vorläuferverbindung in der Reaktionskammer 2 beim Einleiten zu steuern und zum anderen eine Gesamtmenge an der Silizium-Vorläuferverbindung und des auf Silizium basierendem Zwischenprodukt in Schritt (c) in einem Stoffmengenverhältnis von 1 bis 10 mol%, bevorzugt 2 bis 7 mol%, besonders bevorzugt 3 bis 6 mol%, in dem Prozessgas einzustellen. Auch in diesem Ausführungsbeispiel ist die Steuereinheit 4 mit der Messeinheit 3 verbunden.

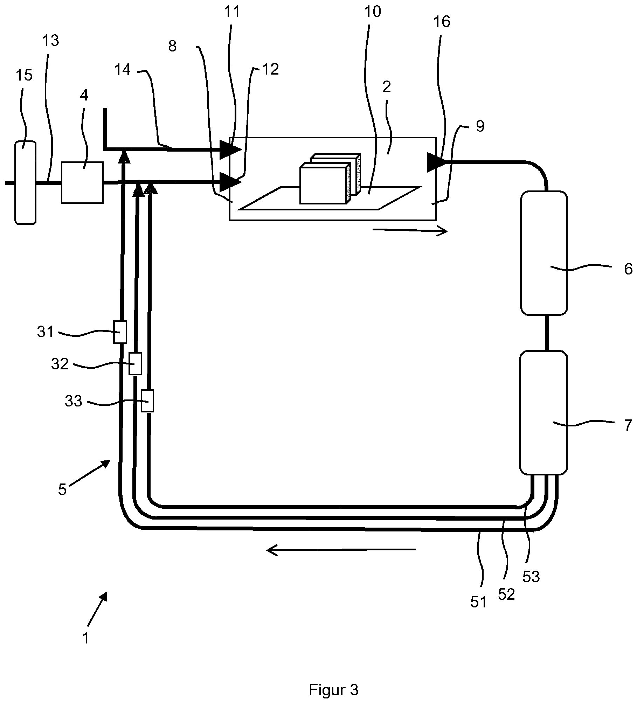

Weiterhin liegt es im Rahmen der Erfindung, dass das überschüssige Prozessgas und/oder die Silizium basierende Zwischenprodukt und/oder die Silizium-Vorläuferverbindung aus das Vorrichtung abgeführt werden. Im vorliegenden Ausführungsbeispiel weist hierfür der Gaswäscher eine Gasauslass 17 mit einer Abfuhrleitung 18 auf, worüber das überschüssige Prozessgas abgeführt wird. Die Erfindung ist jedoch nicht hierauf beschränkt. Weiterhin kann auch die destillative Trennapparatur einen Gasauslass mit einer Abfuhrleitung aufweisen. Figur 3 zeigt ein drittes Ausführungsbeispiel einer erfindungsgemäßen Vorrichtung 1 zur kontinuierlichen Gasphasenabscheidung von Silizium auf Substraten. Auch diese Vorrichtung 1 weist einen weitgehend zu der in Figur 1 beschriebenen Ausgestaltung identischen Aufbau auf, weshalb auf weitere Einzelheiten zunächst nicht einzugehen ist.

Die Kreislaufleitung 5 ist nach der Rückgewinnungseinheit 7 in drei separat geführte Teilleitungen 51, 52, 53 für das Prozessgas, das auf Silizium basierende Zwischenprodukt sowie die Silizium-Vorläuferverbindung aufgespalten. Es liegt im Rahmen der Erfindung, dass mehr als drei separat geführte Teilleitungen der Rückgewinnungseinheit nachgeschaltet sind, insbesondere, um andere Gase, wie beispielsweise Chlorwasserstoff separat rückzuführen. Die jeweiligen Massen- bzw. Volumenflüsse werden mit separaten Messeinheiten 31, 32, 33 bestimmt, welche an den Teilleitungen 51, 52, 53 nach der Rückgewinnungseinheit 7 angeordnet sind. Hieraus lässt sich das Molverhältnis von dem auf Silizium basierenden Zwischenprodukt zu der Silizium-Vorläuferverbindung ableiten. Wie aus Figur 3 hervorgeht, wird das rückgewonnene Prozessgas daraufhin der Fluidzufuhrleitung 14, das auf Silizium basierenden Zwischenprodukt und die Silizium-Vorläuferverbindung der Fluidzufuhrleitung 13 zugeführt.

## Patentansprüche

1. Verfahren zur kontinuierlichen Gasphasenabscheidung von Silizium auf Substraten, welches die folgenden Schritte aufweist:
(a) Einbringen von zumindest einem Substrat in eine Reaktionskammer (2);
(b) Einleiten eines Prozessgases sowie zumindest einer gasförmigen Silizium-Vorläuferverbindung in die Reaktionskammer (2);
(c) Bildung eines gasförmigen Gemisches aus zumindest einem auf Silizium basierenden Zwischenprodukt in Koexistenz mit der gasförmigen Silizium-Vorläuferverbindung und dem Prozessgas in der Reaktionskammer (2);
(d) Bildung einer Siliziumschicht durch Gasphasenabscheidung von Silizium aus der gasförmigen Silizium-Vorläuferverbindung und/oder des auf Silizium basierenden Zwischenprodukts auf dem Substrat;
(e) Abführen eines Überschusses des gasförmigen Gemisches aus der Reaktionskammer (2);
wobei das Verfahren weiterhin einen Schritt (f) aufweist, bei dem zumindest einer der Bestandteile des Überschusses des gasförmigen Gemisches, ausgewählt aus der Silizium-Vorläuferverbindung, dem auf Silizium basierenden Zwischenprodukt und/oder dem Prozessgas, in die Reaktionskammer (2) rückgeführt wird, wobei in dem Verfahren das Einleiten der gasförmigen Silizium-Vorläuferverbindung in die Reaktionskammer (2) derart geregelt wird, dass das Molverhältnis von dem auf Silizium basierenden Zwischenprodukt zu der Silizium-Vorläuferverbindung einen Wert von 0,2:0,8 bis 0,5:0,5, bevorzugt 0,3:0,7 bis 0,5:0,5, besonders bevorzugt 0,5:0,5 im Prozessgas aufweist, wobei es sich bei der Silizium-Vorläuferverbindung um Siliziumtetrachlorid und bei dem auf Silizium basierenden Zwischenprodukt um Trichlorsilan und bei dem Prozessgas um Wasserstoff handelt.

2. Verfahren nach Anspruch 1, **dadurch gekennzeichnet,**
**dass** in Schritt (f) das Molverhältnis des auf Silizium basierenden Zwischenprodukts und der Silizium-Vorläuferverbindung im Überschuss des gasförmigen Gemisches durch eine Messeinheit bestimmt wird.

3. Verfahren nach Anspruch 2, **dadurch gekennzeichnet,**
**dass** das von der Messeinheit ermittelte Molverhältnis des auf Silizium basierenden Zwischenprodukts zu der Silizium-Vorläuferverbindung an eine Steuereinheit weitergeleitet wird, welche Steuereinheit das Einleiten der Silizium-Vorläuferverbindung derart regelt, dass das Molverhältnis von dem auf Silizium basierenden Zwischenprodukt zu der Silizium-Vorläuferverbindung einen Wert von 0,2:0,8 bis 0,5:0,5, bevorzugt 0,3:0,7 bis 0,5:0,5, besonders bevorzugt 0,5:0,5 im Prozessgas aufweist.

4. Verfahren nach einem der Ansprüche 1 bis 3, **dadurch gekennzeichnet, dass** in Schritt (f) der Überschuss des gasförmigen Gemischs von Verunreinigungen befreit und/oder zumindest teilweise durch eine Rückgewinnungseinheit (7) aufgetrennt wird.

5. Verfahren nach Anspruch 4, **dadurch gekennzeichnet,**
**dass** in Schritt (f) das auf Silizium basierende Zwischenprodukt und/oder die Silizium-Vorläuferverbindung und/oder das Prozessgas über die Kreislaufleitung (5) in die Reaktionskammer (2) rückgeführt werden.

6. Verfahren nach einem der Ansprüche 1 bis 5, **dadurch gekennzeichnet, dass** eine Gesamtmenge an der Silizium-Vorläuferverbindung und der auf Silizium basierendem Zwischenprodukt in Schritt (c) in einem Stoffmengenverhältnis von 1 bis 10 mol%, bevorzugt 2 bis 7 mol%, besonders bevorzugt 3 bis 6 mol%, in dem Prozessgas vorliegt.

7. Verfahren nach einem der Ansprüche 1 bis 6, **dadurch gekennzeichnet, dass** die Bildung einer Siliziumschicht durch Gasphasenabscheidung von Silizium aus der Silizium-Vorläuferverbindung und/oder dem auf Silizium basierenden Zwischenprodukt auf dem Substrat bei einem Druck von 0,8 bis 1,2 bar in der Reaktionskammer (2) stattfindet.

8. Verfahren nach einem der Ansprüche 1 bis 7, **dadurch gekennzeichnet, dass** zumindest das Substrat in der Reaktionskammer (2) auf eine Temperatur von 700 °C bis 1400 °C, vorzugsweise auf 1000 °C bis 1300 °C, besonders bevorzugt auf 1100 °C bis 1200 °C aufgeheizt wird.

9. Vorrichtung (1) zur kontinuierlichen Gasphasenabscheidung von Silizium auf Substraten, insbesondere zur Durchführung eines Verfahrens nach einem der Ansprüche 1 bis 8, aufweisend:
- eine Reaktionskammer (2), welche Reaktionskammer (2) zumindest eine Einlassöffnung (8) und eine zumindest eine Auslassöffnung (9) für Substrate umfasst;
- eine Transporteinrichtung (10) zum Transport der Substrate von der Einlassöffnung (8) zu der Auslassöffnung (9) durch die Reaktionskammer (2);
- zumindest zwei Gaseinlässe (11,12) zur Zuführung eines Gases in die Reaktionskammer (2);
- zumindest ein Gasauslass (16) zur Abfuhr des Gases aus der Reaktionskammer (2);
- zumindest zwei Fluidzufuhrleitungen (13, 14), vorzugsweise Gaszufuhrleitungen, welche Fluidzufuhrleitungen (13, 14) mit zwei der Gaseinlässe (11, 12) der Reaktionskammer (2) verbunden sind;
wobei die Vorrichtung (1) zumindest eine Steuereinheit (4) aufweist sowie dass zwischen dem Gasauslass (16) und dem Gaseinlass (12) der Reaktionskammer (2) zumindest eine Kreislaufleitung (5) angeordnet ist, welche Kreislaufleitung (5) mit der Fluidzufuhrleitung (13) sowie dem Gasauslass (16) der Reaktionskammer (2) verbunden ist, wobei die Vorrichtung (1) zumindest eine Messeinheit (3) zur Bestimmung eines Molverhältnisses des auf Silizium basierende Zwischenprodukts und der Silizium-Vorläuferverbindung und/oder einer hierzu äquivalenten Größe aufweist und wobei die Steuereinheit (4) und die Messeinheit (3) derart zusammenwirkend ausgebildet sind, dass ein Durchfluss der Zufuhrleitungen (13, 14) durch die Steuereinheit (4) aufgrund eines von der Messeinheit (3) an die Steuereinheit (4) übermittelten Signals steuer- oder regelbar ist, und wobei das Molverhältnis von dem auf Silizium basierenden Zwischenprodukt zu der Silizium-Vorläuferverbindung einen Wert von 0,2:0,8 bis 0,5:0,5, bevorzugt 0,3:0,7 bis 0,5:0,5, besonders bevorzugt 0,5:0,5 im Prozessgas aufweist, wobei es sich bei der Silizium-Vorläuferverbindung um Siliziumtetrachlorid und bei dem auf Silizium basierenden Zwischenprodukt um Trichlorsilan und bei dem Prozessgas um Wasserstoff handelt.

10. Vorrichtung nach Anspruch 9, **dadurch gekennzeichnet,**
**dass** die Messeinheit (3) an der Kreislaufleitung (5) angeordnet ist.

11. Vorrichtung nach Anspruch 9 oder 10, **dadurch gekennzeichnet,**
**dass** die Messeinheit (3) als Spektrometer, als Massendurchflussmesser oder als Volumendurchflussmesser ausgebildet ist.

12. Vorrichtung nach einem der Ansprüche 9 bis 11, **dadurch gekennzeichnet, dass** zumindest eine der Fluidzufuhrleitungen (13, 14) einen Verdampfer (15) aufweist, welcher zur Überführung der Silizium-Vorläuferverbindung und/oder des auf Silizium basierenden Zwischenprodukts in den gasförmigen Zustand dient.

13. Vorrichtung nach einem der Ansprüche 9 bis 12, **dadurch gekennzeichnet, dass** die Kreislaufleitung (5) einen Gaswäscher (6) und/oder eine Rückgewinnungseinheit (7) aufweist, wobei vorzugsweise die Rückgewinnungseinheit (7) als destillative Trennapparatur ausgebildet ist und/oder einen Trockenabsorber oder -adsorber aufweist.

14. Vorrichtung nach einem der Ansprüche 9 bis 13, **dadurch gekennzeichnet, dass** die Kreislaufleitung (5) zwischen der Rückgewinnungseinheit (7) und der Fluidzufuhrleitung (13, 14) mehrere Teilleitungen (51, 52, 53) aufweist, welche Teilleitungen (51, 52, 53) zum separaten Rückführen des Prozessgases, des auf Silizium basierenden Zwischenprodukts und/oder der Silizium-Vorläuferverbindung dienen, wobei jede Teilleitung (51, 52, 53) eine separate Messeinheit (31, 32, 33) zur Bestimmung des Massenflusses und/oder Volumenflusses des Prozessgases, des auf Silizium basierenden Zwischenprodukts und/oder der Silizium-Vorläuferverbindung aufweist.
